# EUROPÄISCHE PATENTSCHRIFT

(11) **EP 0 529 358 B1**
(45) Veröffentlichungstag und Bekanntmachung des Hinweises auf die Patenterteilung: **23.04.1997**
(21) Anmeldenummer: 92113292.4
(22) Anmeldetag: 05.08.1992
(51) Int. Cl.: G11C 8/04, H04J 3/16, H04Q 11/04

(54) **Speichereinheit mit einem Adressgenerator**
Memory unit with address generator
Unité de mémoire avec générateur d'adresses

(30) Priorität: 21.08.1991 DE 4127579
(43) Veröffentlichungstag der Anmeldung: 03.03.1993
(73) Patentinhaber: Alcatel SEL Aktiengesellschaft, D-70435 Stuttgart (DE)
(72) Erfinder: Koch, Werner, W-7254 Hemmingen (DE)
(74) Vertreter: Schätzle, Albin, Dipl.-Phys.

(56) Entgegenhaltungen:
- DE-A- 3 713 111
- GB-A- 2 056 134
- GB-A- 2 095 441

## Beschreibung

Die Erfindung betrifft eine Speichereinheit mit einem Adressgenerator gemäß dem Oberbegriff des Anspruchs 1.

Bekannte Speichereinheiten enthalten einfache Adressgeneratoren, die nur einen Adressbereich, oder in einem festvorgegebenen Zyklus eine Serie von Adressbereichen erzeugen können.

Bei bekannten Anwendungsfällen, wie z.B. bei der Verarbeitung von Datenströmen in digitalen Übertragungsnetzen der synchronen digitalen Hierarchie (SDH), in der sogenannte, nach den CCITT-Empfehlungen G.707 bis G.709 strukturierte STM-N Rahmen übertragen werden, ist es notwendig, Speichereinheiten flexibel zu gestalten. In einem STM-N Rahmen ist die zu übertragende Nutzinformation in einen oder mehrere festdefinierten virtuelle Containern enthalten. Eine Speichereinheit muß nun in der Lage sein, den einzelnen Containern in einem elastischen Speicher unterschiedliche Adressen zuzuordnen. Da ein STM-N Rahmen unterschiedlich strukturierbar, d.h. mit unterschiedlichen Kombinationsmöglichkeiten von virtuellen Containern z.B. VC-11, VC-21, VC-12 oder VC-22 belegt sein kann, müssen die Adressbereiche im elastischen Speicher flexibel definierbar sein.

Der Erfindung liegt daher die Aufgabe zugrunde, eine einfache Speichereinheit zu schaffen, in der temporär mehrere Adressbereiche unterschiedlicher Größe und eine variable Anzahl von Adressbereichen erzeugt werden können.

Die Aufgabe wird durch die Merkmale des Anspruchs 1 gelöst. Vorteilhafte Ausgestaltungen der Erfindung sind den übrigen Ansprüchen zu entnehmen.

Ein Ausführungsbeispiel wird anhand der Figuren 1 bis 5 beschrieben. Es zeigen:
- Fig. 1: ein Blockschaltbild einer Speichereinheit mit dem erfindungsgemäßen Adressgenerator,
- Fig. 2: die Speicheradressierung für einen Speicherbereich über der Zeit aufgetragen,
- Fig. 3: einen Teil eines Rahmens in dem das zu speicherende Signal übertragen wird,
- Fig. 4: eine erfindungsgemäße Speichereinheit zum Zwischenspeichern des Nutzteils eines STM-N Rahmens, und
- Fig. 5: eine mögliche Strukturierungsmöglichkeit eines STM-N Rahmens.

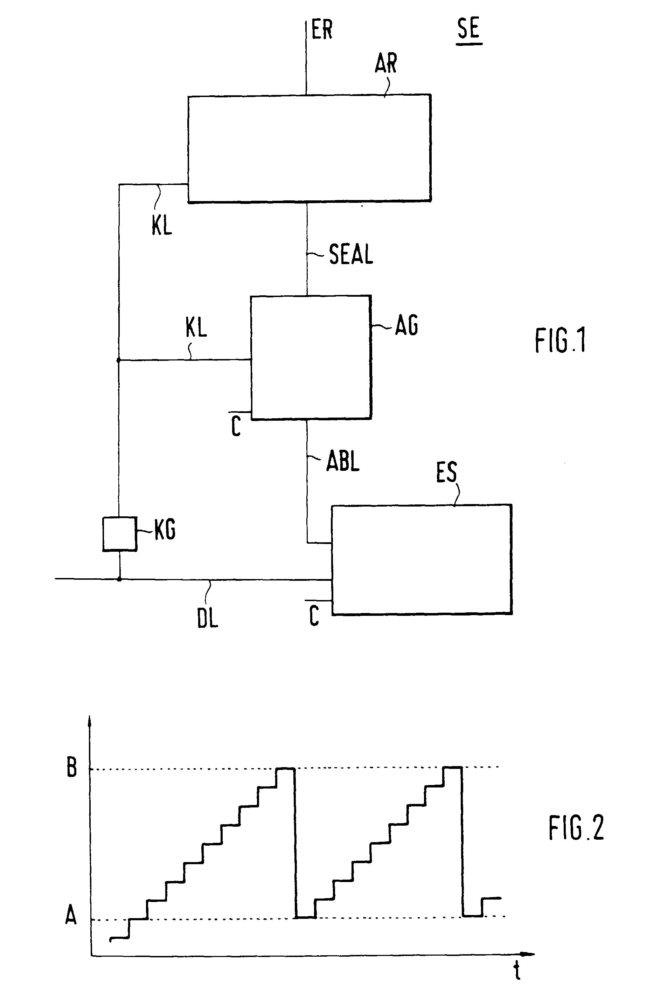

In Fig. 1 ist ein Ausführungsbeispiel einer Speichereinheit SE mit einem erfindungsgemäßen Adressgenerator AG als Blockschaltbild abgebildet. Im Ausführungsbeispiel ist der Adressgenerator AG mit einem programmierbaren Adressregister AR, mit einem elastischen Speicher ES und mit einem Kennzahlgenerator KG verbunden. Der Kennzahlgenerator KG ist ebenfalls mit dem Adressregister AR verbunden. Er generiert aus dem Datenstrom, der in dem elastischen Speicher ES zwischengespeichert werden soll, für vorgegebene Teilsignale Kennzahlen, die dem Adressregister AR und dem Adressgenerator AG über eine Kennzahlleitung KL mitgeteilt werden. Hierzu ist der Kennzahlgenerator KG mit der Datenleitung DL verbunden, die auch zum elastischen Speicher führt.

Die Speichereinheit SE dient dazu, diejenigen Teilsignale eines STM-N Rahmens, die einen Übertragungskanal bilden, auf dem elastischen Speicher ES jeweils in einem Adressbereich des elastischen Speichers ES zwischenzuspeichern. Hierzu wird dem Adressregister AR und dem Adressgenerator AG über die Kennzahlleitung KL von dem Kennzahlgenerator KG mitgeteilt, welches Teilsignal zum jeweiligen Zeitpunkt am Dateneingang des elastischen Speichers ES anliegt. Den einzelnen Kanälen wird dabei eine Kennzahl zugeordnet. Um das wesentliche der Erfindung einfacher darstellen zu können, wird darauf verzichtet, die aufgrund der unterschiedlichen Laufzeiten erforderlichen Verzögerungselemente zu beschreiben.

Im Adressregister AR sind die Start- und Endadressen der einzelnen Kanäle gespeichert. Sie werden über die Start- und Endadressleitung SEAL an den Adressgenerator AG übermittelt sobald eine entsprechende Kennzahl an der Kennzahlleitung KL anliegt. Im Adressgenerator AG befindet sich ein Zählwerk, daß den Adresswert, wie in Fig. 2 abgebildet, bei jedem erneuten Anliegen einer gleichen Kennzahl um den Betrag eins erhöht, bis die Endadresse des durch diese Kennzahl identifizierten Adressbereichs erreicht ist. In der Fig. 2 ist die Startadresse mit A und die Endadresse mit B bezeichnet. Die Endadresse wird dem Adressgenerator AG für die jeweils vorliegende der Kennzahl vom Adressregister AR mitgeteilt. Die Endadresse wird durch einen Komperator identifiziert. Liegt die Endadresse vor, wird der Speicherwert nicht weiter erhöht, sondern auf den durch die vorliegende Kannzahl identifizierten Startwert zurückgesetzt.

Da in einem STM-N Rahmen die Teilsignale der Kanäle zyklisch versetzt gesendet werden, erscheinen die Kennzahlen auf der Kennzahlleitung KL ebenfalls zyklisch. Ein RAM speichert dabei für jede Kennzahl einen Adresswert, der durch die nachfolgenden gleichen Kennzahlen erhöht wird.

Bei der Erstbeschreibung des Speicherelements, oder wenn z.B. die Anzahl oder die Belegung der Kanäle verändert wird, was ebenfalls zu einer Veränderung der Adressbereiche führt, werden den Kennzahlen erstmalig bzw. neue Adressbereiche zugeordnet. Ein zentraler Rechner ZR kennt die Erstbelegung oder Neubelegung der Zeitschlitze im STM-N Rahmen und teilt dem Adressregister AR mit, welcher Kennzahl welche Start- und Endadresse zuzuordnen sind. Liegt nun an der Kennzahlleitung KL eine Kennzahl erstmalig oder mit neu zugeordneten Start- und Endadressen an, werden dem Adressgenerator AG über die Start- und Endadressleitung SEAL die neuen Start- und Endadressen mitgeteilt. Bei einer Erstbeschreibung des RAM's zählt der Adressgenerator von einer beliebigen Adresse an die möglichen Adressen soweit durch, bis er die Endadresse eines durch die Kennzahl identifizierten Adressbereichs erreicht. Dann wird das RAM für die jeweilige Kennzahl auf die Startadresse gesetzt, beim nächsten Vorliegen dieser Kennzahl hat der Adressgenerator für diese Kennzahl den eingeschwungenen Zustand erreicht.

Wird während der Übertragung die Kanalbelegung verändert, liegt durch die Kennzahl identifiziert, der entsprechende Start- und Endwert an der Start- und Endadressleitung SEAL an. Das Zählwerk des Adressgenerators AG zählt den Adressbereich soweit durch, bis die neue anliegende Endadresse erreicht ist, dabei wird durch Erreichen der Endadresse für die jeweilige Kennzahl im RAM die neue Startadresse gesetzt.

Auf die beschriebene Weise können die Adressbereiche über den zentralen Rechner ZR gesteuert und entsprechend der Kanalbelegung zentral geändert werden.

Im Ausführungsbeispiel werden aus dem zwischenzuspeichernden Datenstrom die Kennzahl oder die Kennzahlen abgeleitet und aus einer Kennzahl ein Adressbereich generiert, der vom Adressgenerator über die Adressbereichsleitung ABL dem Eingang für Schreibadresse des elastischen Speicher ES zugeführt wird.

Eine Leseadresse kann auf die gleiche Weise erzeugt werden. In diesem Fall wird die Kennzahl gleichzeitig mit einem Leerrahmen für den ausgehenden Datenstrom von einer Rechnereinheit erzeugt.

Die Art und Weise der Kennzahlerzeugung soll nicht Gegenstand der Erfindung sein, sie hängt stark von der Art des Datenstroms ab. Stellt der Datenstrom ein STM-N Rahmen dar, erhält der Kennzahldetektor seine Information über Art und die Belegung der Kanäle von der zentralen Recheneinheit ZR.

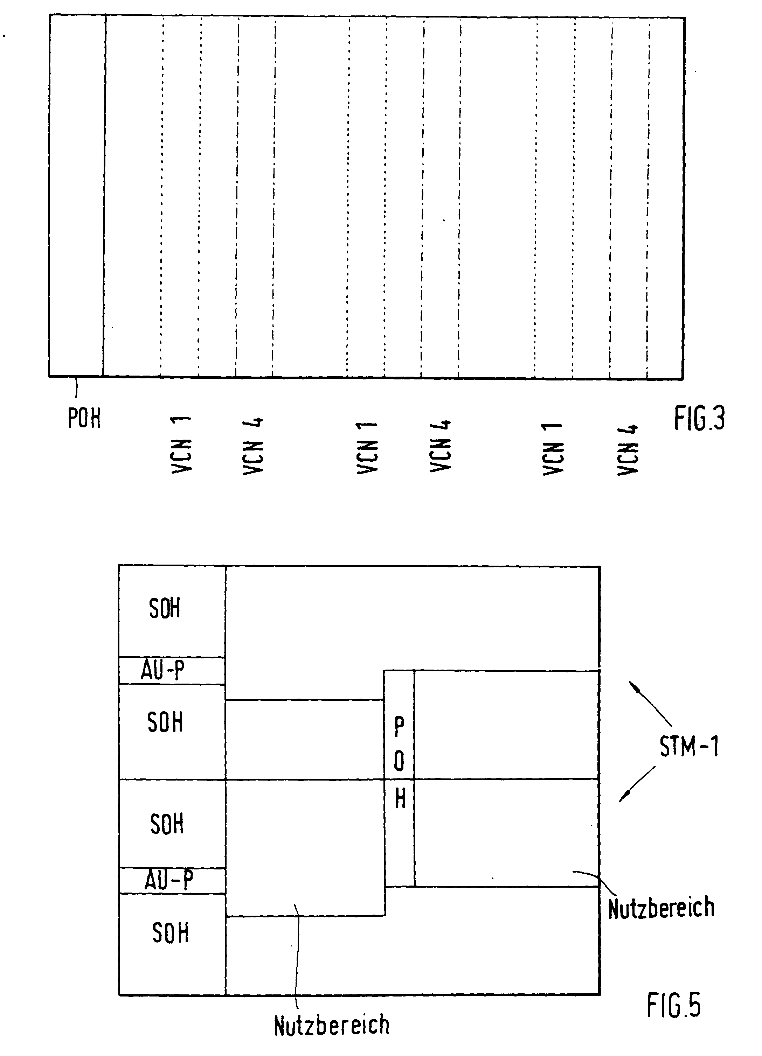

In Fig. 3 ist der Nutzbereich eines STM-1 Rahmens in vereinfachter Form abgebildet. Die linke Spalte stellt den Kopfteil POH des Nutzteils dar. Ein solcher Nutzteil besteht in bekannter Weise aus in 261 Spalten und 9 Zeilen angeordneten 8 Bit-Wörtern. Zum Aufbau der Kanäle stehen im STM-1 Rahmen virtuelle Container VC zur Verfügung. In Fig. 3 sind beispielhaft zwei virtuelle Container VCN1 und VCN4 abgebildet, die im Rahmen äquidistant angeordnet sind. Die Ziffer 1 und 4 stellen für diese virtuellen Container die Kennzahlen dar. Für den Fall, daß die virtuellen Container virtuelle Container VC-12 sind, weist der Nutzbereich maximal 63 virtuelle Container auf. Jeder dieser virtuellen Container erhält, sofern er belegt wird, eine Kennzahl, womit maximal 63 Kennzahlen vorliegen.

Liegt ein virtueller Container VC-4 vor, werden Elemente dieses Containers mit nur einer Kennzahl identifiziert. Bei Vorliegen einer Mischung unterschiedlicher virtueller Container, z.B. aus VC-11, VC-12, VC-21, VC-22, VC-31 und VC-32, oder einer durch die CCITT-Empfehlung zugelassene Mischung, ergibt sich eine mögliche Anzahl von 3 bis 63 virtuellen Containern. Da die Lage und die Kombination der virtuellen Container vielseitig wählbar ist und jedem virtuellen Container einen Adressbereich im elastischen Speicher ES zugewiesen wird, muß der Adressgenerator AG in der Lage sein, eine unterschiedliche Anzahl von Adressbereichen mit gegebenenfalls unterschiedlicher Größe im elastischen Speicher generieren zu können.

In den virtuellen Containern befindliche Stopfbyts sind dem Kennzahlgenerator oder der Rechnereinheit bekannt. Stopfbyts werden mit keiner Kennzahl versehen, wodurch die reine Information im elastischen Speicher ES zwischengespeichert werden kann.

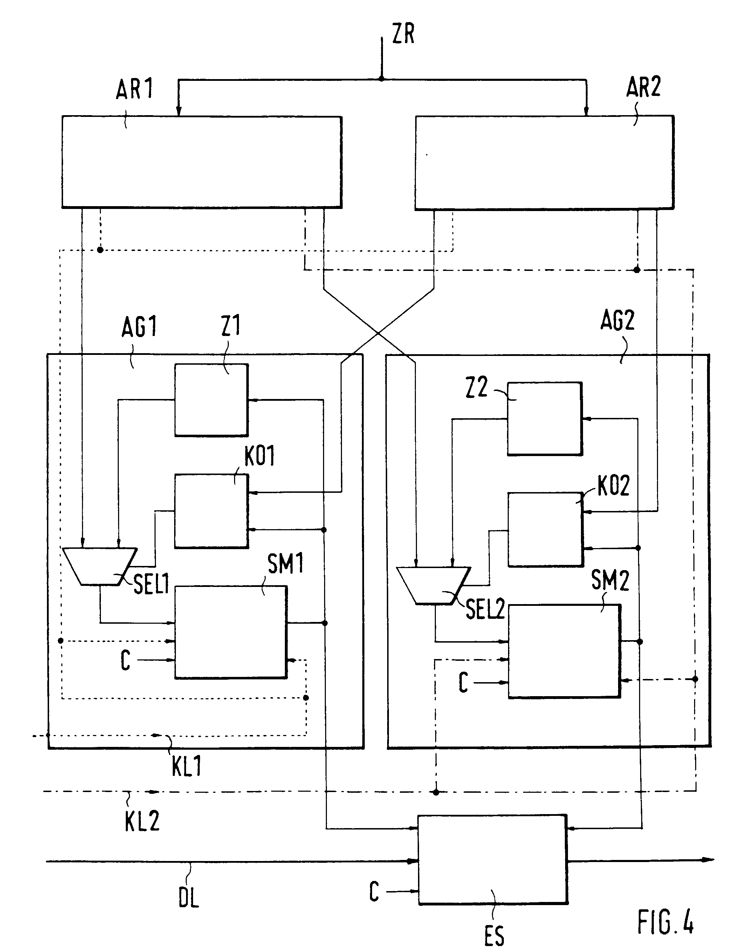

Eine vorteilhafte Anordnung und Ausgestaltung einer Speichereinheit SE' wird im folgenden anhand der Fig. 4 beschrieben. Die Speichereinheit SE' hat im Ausführungsbeispiel die Aufgabe ein ankommendes STM-1 Rahmen in ein anderes ausgehendes STM-1∗∗ Rahmen umzuformen. In einem STM-1 Rahmen besteht der Nutzbereich, wie in Fig. 5 abgebildet, aus einem Teil Path Overhead POH und einem Bereich, dem die virtuellen Container zugeordnet sind. Es ist dabei nach der CCITT-Empfehlung nicht erforderlich, daß der Teil Path Overhead in der ersten Spalte des Nutzbereichs angeordnet ist, sondern dieser kann irgendwo im Nutzbereich angeordnet sein. Dies hat zur Folge, daß eine Zeile eines im STM-1 Rahmen enthaltenen Nutzbereichs, wie in Fig. 5 abgebildet, auf zwei Zeilen des STM-1 Rahmens verteilt ist. In einem STM-1** Rahmen ist der Nutzbereich im Rahmen so verschoben, daß eine Zeile eines Nutzbereichs auch immer in einer Zeile des Rahmens angeordnet ist. Dies Anordnung ermöglicht eine einfachere nachfolgende Bearbeitung des Nutzbereichs, z.B. in einem sogenannten Cross Connect.

Die Umwandlung eines STM-1 Rahmens in ein STM-1** Rahmen erfolgt mit der Speichereinheit SE' gemäß Fig. 4. Die Speichereinheit SE' gemäß Fig. 4 unterscheidet sich gegenüber der Speichereinheit SE gemäß Fig. 1, dadurch daß auch die Vorrichtungen zur Adressierung der Leseadresse und die Adressgeneratoren AG1, AG2 im Detail angegeben, sowie die Adressregister AR1, AR2 in anderer Weise organisiert sind.

Die Schreibadresse des elastischen Speichers ES wird in einem Adressgenerator AG1 und die Leseadresse in einem Adressgenerator AG2 erzeugt. Die Adressgeneratoren AG1 und AG2 sind gleichermaßen aufgebaut und bestehen jeweils aus einem Speicherelement SM1, SM2, das jeweils mit dem Ausgang mit dem Eingang für Schreibadressen oder Leseadressen des elastischen Speichers ES sowie jeweils im Adressgenerator AG1, AG2 mit einem Eingang des Komparators KO1, KO2, und einem Eingang eines Addierwerkes Z1, Z2 verbunden ist. Das Adressregister AR ist in zwei Teile AR1, AR2 aufgeteilt, von denen jedes Teil doppelt ausgelegt ist. In einem Teil befinden sich die Start- und im anderen Teil die Endadressen zu jedem Adressbereich. Durch die doppelte Ausgestaltung der Adressregisterteile können sowohl der Adressgenerator AG1 sowie der Adressgenerator AG2 gleichzeitig auf die Teile AR1, AR2 des Adressregisters AR zugreifen.

Der Ausgang des Addierwerkes Z1 und ein Ausgang des Teils AR1 des Adressregisters, in dem die Startadressen anliegen, sind auf die Eingänge eines im Adressgenerator AG1 befindlichen Selektor SEL1 geführt, wobei über eine Steuerleitung, die mit dem Ausgang des Komperators KO1 verbunden ist, einer der beiden Eingänge durchgeschaltet werden kann. Der Ausgang des Selektros SEL1 ist mit dem Dateneingang des Speicherelements SM1 verbunden. Der zweite Eingang des Komperators KO1 ist mit dem Teil AR2 des Adressregisters AR verbunden. Das Speicherelement SM1 sowie die beiden Teile AR1 und AR2 des Adressregisters sind mit einer Kennzahlleitung KL1 verbunden. Der Funktionsablauf der Speichereinheit wurde schon zu Fig. 1 prinzipiell beschrieben. Im Ausführungsbeispiel zu Fig. 5 läuft er wie folgt ab:

Eine Kennzahl liegt gleichzeitig am Speicherelement SM1, sowie an den Leseeingängen der Adressregisterteile AR1 und AR2 an. Dadurch wird eine Startadresse, die durch die Kennzahl identifiziert wird, vom Adressregisterteil AR1 an einen Eingang des Selektors SEL1 und die zugehörige Endadresse vom Adressregisterteil AR2 an einen Eingang des Komperators KO1 gegeben, gleichzeitig wird ein durch die Kennzahl vorgegebener Speicherplatz im Speicherelement SM1 adressiert. Der Inhalt des Adressierten Speicherplatzes wird dem Eingang für Schreibadressen des elastischen Speichers, einem Eingang des Komperators K01 und dem Eingang des Addierwerks Z1 zugeführt. Im eingeschwungenen Zustand, d.h. wenn ein Kanal bereits durchgeschaltet ist, stellt dieser Adresswert für eine bestimmte Kennzahl die aktuelle Schreibadresse im elastischen Speicher ES dar. Wird ein Kanal erst aufgebaut, ist dies dem Übertragungssystem über den zentralen Rechner ZR bekannt und die eingeschriebenen Daten werden noch nicht verwertet. Im Komperator KO1 wird festgestellt, ob der anliegende Adresswert mit der Endadresse übereinstimmt. Der Adresswert wird im Addierwerk Z1 um den Betrag eins erhöht und der erhöhte Wert dem Eingang E2 des Selektors SEL zugeführt. Liegen am Komperator K01 zwei verschiedene Wert an, wird im Selektor SEL1 durch den Komperator KO1, der mit dem Addierwerk Z1 verbundene Eingang durchgeschaltet und im Speicherelement SM1 der vorhergehende Wert zu dieser Kennzahl mit dem im Addierwerk Z1 erhöhten Adresswert überschrieben.

Liegen am Komperator K01 zwei gleiche Werte an, bedeutet dies, daß beim Beschreiben des elastischen Speichers SE die Endadresse eines Adressbereichs erreicht ist. In diesem Fall wird der mit den Adressregisterteil AR verbundenen Eingang des Selektors SEL1 durchgeschaltet, wodurch der aktuell gespeicherte Adresswert, die Endadresse, mit der Startadresse überschrieben wird.

Der Adressgenerator AG2 ist wie der Adressgenerator AG aufgebaut und funktioniert in gleicher Weise. Der Unterschied liegt lediglich daran, daß er zur Erzeugung der Leseadressen mit dem Leseeingang des elastischen Speichers ES verbunden ist und über eine andere Kennzahlleitung KL2 durch einen anderen Kennzahlgenerator versorgt wird.

Die Start- und Endadressen sind im Ausführungsbeispiel für eine bestimmte Kennzahl sowohl für die Schreib- als auch für die Leseadresse die gleichen. Die unterschiedliche Adressierung liegt in diesem Fall in der Reihenfolge der generierten Kennzahlen.

Für die Speichereinheit SE' wurden nur solche Elemente AR, Z, KO, SEL, SM, ES gewählt, die in sogenannter Gate-Array-Technik integriert angeordnet werden können. Als elastischer Speicher ES werden dabei sogenannte Makrozellen benutzt, die von Gate-Array-Herstellern als funktionelle Einheit angeboten werden und deren Länge und Tiefe frei wählbar ist.

## Patentansprüche

1. Speichereinheit mit einem Adressgenerator zum sukzessiven Erzeugen von Adressbereichen, die durch eine Start- und Endadresse begrenzt sind und über die wenigstens Teile eines Datenstroms sukzessive in einen elastischen Speicher eingeschrieben und/oder ausgelesen werden,
**dadurch gekennzeichnet,**
- daß der Adressgenerator (AG) unterschiedliche Adressbereiche erzeugen kann und hierzu mit einem Adressregister (AR) verbunden ist, über das er die Start- und Endadressen von Adressbereichen erhält,
- daß der Adressgenerator (AG) mit dem Eingang für Schreibadressen und/oder Leseadressen des elastischen Speichers (ES) verbunden ist,
- daß das Adressregister (AR) und der Adressgenerator (AG) mit einer Kennzahl versorgt werden, mit der im Adressregister (AR) die Start- und Endadresse eines über die Kennzahl identifizierten Adressbereichs ausgegeben wird, und mit der im Adressgenerator (AG) ein durch die Kennzahl identifizierter Speicherplatz adressierbar ist,
- daß im Adressgenerator (AG) Mittel vorhanden sind, die bei Anliegen der Kennzahl einen Adressbereich ausgehend von der Startadresse bis hin zur Endadresse zyklisch durchzählen und die durchgezählten Adressen an den elastischen Speicher ausgeben, und
- daß Mittel Adressgenerator vorhanden sind, die bei Erreichen der Endadresse beim Durchzählen des Adressbereichs den Speicherplatz für diesen Adressbereich auf die durch die Kennzahl identifizierte Startadresse setzen.

2. Speichereinheit nach Anspruch 1, dadurch gekennzeichnet, daß die Kennzahl aus dem einzuschreibenden Datenstrom abgeleitet oder von einer Rechnereinheit vorgegeben ist.

3. Speichereinheit nach einem der Ansprüche 1 oder 2, dadurch gekennzeichnet,
- daß der Adressgenerator (AG) ein Speicherelement (SM1, SM2), einen Komperator (KO1, KO2), ein Addierwerk (Z1, Z2) und einen Selektor (SEL1, SEL2) enthält, daß der Datenausgang des Speicherelements (SM1, SM2) den Ausgang des Adressgenerators (AG, AG1, AG2) darstellt und mit einem ersten Eingang des Komperators (KO1 ,KO2) sowie dem Eingang des Addierwerks (Z1, Z2) verbunden ist,
- daß derjenige Ausgang des Adressregisters (AR1, AR2) an dem die Startadresse anliegt oder der Ausgang des Addierwerks (Z1, Z2) wahlweise über den Selektor (SEL1, SEL2) auf den Dateneingang des Speicherelements (SM1, SM2) durchschaltbar ist,
- daß der Schaltzustand des Selektors (SEL1, SEL2) über den Ausgang des Komperators (KO1, KO2) gesteuert wird,
- daß an einem zweiten Eingang des Komperators (KO1, KO2) die Endadresse des durch die Kennzahl identifizierten Adressbereichs anliegt,
- daß der Selektor (SEL1, SEL2) denjenigen Ausgang des Adressregisters (AR1, AR2, AR), an dem die Startadresse anliegt, durchschaltet, wenn am Komperator (K01, K02) gleiche Eingangssignale anliegen, und
- daß die Kennzahl an den Adresseingängen des Speicherelements (SM1, SM2) anliegt.

4. Speichereinheit nach Anspruch 3, dadurch gekennzeichnet, daß der Datenstrom im Nutzbereich eines nach den CCITT-Empfehlungen G.707 bis G.709 strukturierten STM-N Rahmens übertragen wird und ein Teil des STM-N Rahmens den Kanal eines virtuellen Containers darstellt.

5. Speichereinheit nach Anspruch 4, dadurch gekennzeichnet, daß der Adressgenerator (AG) sukzessive die Adressen mehrerer Kanäle bildet, die in unterschiedlichen virtuellen Containern enthalten sind.

6. Speichereinheit nach einem der Ansprüche 1 bis 5, dadurch gekennzeichnet, daß sie zwei Adressgeneratoren (AG1, AG2) enthält, und der erste Adressgenerator (AG1) mit dem Eingang für Schreibadressen des elastischen Speichers (ES) und der zweite Adressgenerator (AG2) mit dem Eingang für Leseadressen des elastischen Speichers (ES) verbunden ist.

## Claims

1. Memory unit having an address generator for successively generating address areas which are limited by a starting and a finishing address and via which at least parts of a data flow are successively written into an elastic memory and/or read out of it, characterized
- in that the address generator (AG) can generate different address areas and is connected for this purpose to an address register (AR) via which it receives the starting and finishing addresses of address areas,
- in that the address generator (AG) is connected to the input for write addresses and/or read addresses of the elastic memory (ES),
- in that the address register (AR) and the address generator (AG) are provided with a code number with which the starting and finishing address of an address area identified by means of the code number is outputted in the address register (AR) and with which a memory location identified by the code number can be addressed in the address generator (AG),
- in that there are present in the address generator (AG) means which, if the code number is present, count cyclically through an address area starting from the starting address right up to the finishing address and output the addresses counted through to the elastic memory,
- in that there are means present in the address generator (AG) which, on reaching the final address when counting through the address area, set the memory location for said address region to the starting address identified by the code number.

2. Memory unit according to Claim 1, characterized in that the code number is derived from the data flow to be written in or is specified by a computer unit.

3. Memory unit according to one of Claims 1 or 2, characterized
- in that the address generator (AG) comprises a memory element (SM1, SM2), a comparator (K01, K02), an adder (Z1, 22) and a selector (SEL1, SEL2), in that the data output of the memory element (SM1, SM2) is the output of the address generator (AG, AG1, AG2) and is connected to a first input of the comparator (KO1, KO2) and also to the input of the adder (Z1, Z2),
- in that that output of the address register (AR1, AR2) at which the starting address is present or the output of the adder (Z1, Z2) can optionally be switched through via the selector (SEL1, SEL2) to the data input of the memory element (SM1, SM2),
- in that the switching state of the selector (SEL1, SEL2) is controlled via the output of the comparator (KO1, KO2),
- in that the final address of the address area identified by the code is present at a second input of the comparator (KO1, KO2),
- in that the selector (SEL1, SEL2) switches through that output of the address register (AR1, AR2, AR) at which the starting address is present if identical input signals are present at the comparator (KO1, KO2), and
- in that the code number is present at the address inputs of the memory element (SM1, SM2).

4. Memory unit according to Claim 3, characterized in that the data flow in the useful area of an STM-N frame structured according to CCITT recommendations G.707 to G.709 is transmitted and a part of the STM-N frame is the channel of a virtual container.

5. Memory unit according to Claim 4, characterized in that the address generator (AG) successively forms the addresses of a plurality of channels which are contained in different virtual containers.

6. Memory unit according to one of Claims 1 to 5, characterized in that it contains two address generators (AG1, AG2) and the first address generator (AG1) is connected to the input for write addresses of the elastic memory (ES) and the second address generator (AG2) is connected to the input for read addresses of the elastic memory (ES).

## Revendications

1. Unité de mémoire avec une génératrice d'adresses pour la création de gammes d'adresses successives limitées par une adresse de départ et une adresse finale et par l'intermédiaire desquelles au moins des parties d'un courant de données sont successivement écrites dans et/ou lues d'une mémoire élastique,
**caractérisée par le fait que**
- la génératrice d'adresses (AG) peut créer différentes gammes d'adresses et est pour cela reliée à un registre d'adresses (AR) duquel elle tire les adresses de départ et les adresses finales de gammes d'adresses;
- la génératrice d'adresses (AG) est reliée à l'entrée d'adresses d'écriture et/ou d'adresses de lecture de la mémoire élastique (ES);
- le registre d'adresses (AR) et la génératrice d'adresses (AG) ont chacun un indice permettant de lire dans le registre d'adresses (AR) l'adresse de départ et l'adresse finale d'une gamme d'adresses identifiée à l'aide dudit indice, et permettant également d'adresser, dans la génératrice d'adresses (AG), une place de mémoire identifiée par l'indice;
- dans la génératrice d'adresses (AG), il existe des instruments qui, lorsque l'indice est détecté, balaient de manière cyclique une gamme d'adresses, partant de l'adresse de départ jusqu'à l'adresse finale, et stockent les adresses ainsi balayées dans la mémoire élastique, et
- dans la génératrice d'adresses (AG), il existe des instruments qui, lorsque l'adresse finale est atteinte lors du balayage de la gamme d'adresses, fixe pour la place de mémoire de cette gamme d'adresses l'adresse de départ identifiée par l'indice.

2. Unité de mémoire conformément à la revendication 1, caractérisée par le fait que l'indice est dérivé du courant de données à écrire en mémoire ou défini au préalable par un ordinateur.

3. Unité de mémoire conformément à l'une des revendications 1 ou 2, caractérisée par le fait que
- la génératrice d'adresses (AG) comporte un élément de mémoire (SM1, SM2), un comparateur (KO1, KO2), un additionneur (Z1, 22) et un sélecteur (SEL1, SEL2), que la sortie des données de l'élément de mémoire (SM1, SM2) représente la sortie de la génératrice d'adresses (AG, AG1, AG2) et est reliée à une première entrée du comparateur (KO1, K02) ainsi qu'à l'entrée de l'additionneur (Z1, 22);
- que la sortie du ou bien la sortie de l'additionneur (Z1, 22) peut être commutée facultativement par l'intermédiaire du sur l'entrée de données de l'élément de mémoire (SM1, SM2);
- la position de commutation du sélecteur (SEL1, SEL2) est commandée par l'intermédiaire de la sortie du comparateur (KO1, KO2);
- l'adresse finale de la gamme d'adresses identifiée par l'indice est présente à la seconde entrée du comparateur (KO1, KO2);
- le sélecteur (SEL1, SEL2) commute la sortie du registre d'adresses (AR1, AR2, AR) auquel l'adresse de départ est présente lorsque des signaux d'entrée égaux sont présents au comparateur (KO1, KO2), et que
- l'indice est présent aux entrées d'adresses de l'élément de mémoire (SM1, SM2).

4. Unité de mémoire conformément à la revendication 3, caractérisée par le fait que le courant de données dans le domaine utile d'une trame STM-N structurée conformément aux recommandations CCITT G.707 à G.709 et une partie de la trame STM-N représente le canal d'un conteneur virtuel.

5. Unité de mémoire conformément à la revendication 4, caractérisée par le fait que la génératrice d'adresse (AG) génère successivement des adresses de plusieurs canaux compris dans différents conteneurs virtuels.

6. Unité de mémoire conformément à l'une des revendications 1 à 5, caractérisée par le fait qu'elle comporte deux génératrices d'adresses (AG1, AG2), et que la première génératrice d'adresse (AG1) est reliée à l'entrée d'adresses d'écriture de la mémoire élastique (ES) et la deuxième première génératrice d'adresse (AG2) à l'entrée d'adresses de lecture de la mémoire élastique (ES).
